# EUROPÄISCHE PATENTSCHRIFT

(11) **EP 4 193 135 B1**
(45) Veröffentlichungstag und Bekanntmachung des Hinweises auf die Patenterteilung: **01.10.2025**
(21) Anmeldenummer: 21751535.2
(22) Anmeldetag: 26.07.2021
(51) Int. Cl.: G01M 17/007, G08G 1/16, G06N 5/01

(54) **COMPUTERIMPLEMENTIERTES VERFAHREN ZUM BEREITSTELLEN EINES TEST-VERLAUFS ZU TESTENDER VERKEHRSSZENARIEN**
COMPUTER-IMPLEMENTED METHOD FOR PROVIDING A TEST PROCESS FOR TRAFFIC SCENARIOS TO BE TESTED
PROCÉDÉ MIS EN OEUVRE PAR ORDINATEUR PERMETTANT LA FOURNITURE D'UN PROCESSUS DE TEST DESTINÉ À DES SCÉNARIOS DE TRAFIC À TESTER

(30) Priorität: 05.08.2020 DE 102020120632; 07.01.2021 DE 102021100149
(43) Veröffentlichungstag der Anmeldung: 14.06.2023
(73) Patentinhaber: dSPACE GmbH, 33102 Paderborn (DE)
(72) Erfinder: BOUILLON, Patrick, 33102 Paderborn (DE); HÜLLERMEIER, Eyke, 33104 Paderborn (DE); HORSTMANN, Jens, 33098 Paderborn (DE); RASCHE, Rainer, 33098 Paderborn (DE)
(86) Internationale Anmeldenummer: PCT/EP2021/070815
(87) Internationale Veröffentlichungsnummer: WO 2022/028935

(56) Entgegenhaltungen:
- WO-A1-2017/210222
- CN-B- 108 332 977
- HALIL BEGLEROVIC ET AL: "Polar Occupancy Map - A Compact Traffic Representation for Deep Learning Scenario Classification", 2019 IEEE INTELLIGENT TRANSPORTATION SYSTEMS CONFERENCE (ITSC), 27 October 2019 (2019-10-27), pages 4197 - 4203, XP055648801, ISBN: 978-1-5386-7024-8, DOI: 10.1109/ITSC.2019.8916947
- GRUNER RICHARD ET AL: "Spatiotemporal representation of driving scenarios and classification using neural networks", 2017 IEEE INTELLIGENT VEHICLES SYMPOSIUM (IV), IEEE, 11 June 2017 (2017-06-11), pages 1782 - 1788, XP033133943, DOI: 10.1109/IVS.2017.7995965

## Beschreibung

Die vorliegende Erfindung betrifft ein computerimplementiertes Verfahren zum Bereitstellen eines Szenario-Test-Verlaufs zu testenden Szenarien insbesondere Verkehrsszenarien, für Tests einer Vorrichtung zur zumindest teilweisen autonomen Führung eines Verkehrsmittels. Die vorliegende Erfindung betrifft des Weiteren eine Testeinheit, für die ein Szenario-Test-Verlauf von zu testender Verkehrsszenarien ausgeführt wird. Die vorliegende Erfindung betrifft darüber hinaus ein Computerprogramm und einen computerlesbaren Datenträger.

### Stand der Technik

Fahrassistenzsysteme wie z.B. ein adaptiver Geschwindigkeitsregler und/oder Funktionen für das hochautomatisierte Fahren können mithilfe diverser Überprüfungsmethoden verifiziert bzw. validiert werden. Dabei können insbesondere Hardware-in-the-Loop Verfahren, Software-in-the-Loop Verfahren, Simulationen und/oder Testfahrten verwendet werden.

Der Aufwand, insbesondere der Zeit- und/oder Kostenaufwand, zum Testen derartiger Fahrzeugfunktionen unter Verwendung der oben genannten Überprüfungsmethoden ist dabei typischerweise sehr hoch, da eine große Anzahl potenziell möglicher Fahrsituationen getestet werden muss.

Ein zumindest teilweise autonomes Verkehrsmittel ausschließlich auf der Straße mit Fahrtstrecken über Milliarden Kilometer zu testen ist aus Zeit- und Kostengründen nicht möglich. Zudem würden viele redundante Testkilometer entstehen, während kritische und ungewöhnliche Situationen, die aber relevant für die Fähigkeiten des zumindest teilweise autonomen Fahrzeugs sind, nicht auftreten.

Dies kann insbesondere zu einem hohen Aufwand für Testfahrten als auch für Simulationen führen. DE 10 2017 200 180 A1 gibt ein Verfahren zur Verifizierung und/oder Validierung einer Fahrzeugfunktion an, welche dafür vorgesehen ist, ein Fahrzeug in Längs- und/oder Querrichtung autonom zu führen.

Das Verfahren umfasst ein Ermitteln, auf Basis von Umfelddaten bezüglich eines Umfelds des Fahrzeugs, einer Test-Steueranweisung der Fahrzeugfunktion an einen Aktuator des Fahrzeugs, wobei die Test-Steueranweisung nicht durch den Aktuator umgesetzt wird.

Das Verfahren umfasst des Weiteren ein Simulieren, auf Basis von Umfelddaten und unter Verwendung eines Verkehrsteilnehmer-Modells bezüglich zumindest eines Verkehrsteilnehmers im Umfeld des Fahrzeugs, einer fiktiven Verkehrssituation, die vorliegen würde, wenn die Test-Steueranweisung umgesetzt worden wäre.

Das Verfahren umfasst ferner ein Bereitstellen von Testdaten in Bezug auf die fiktive Verkehrssituation. Die Fahrzeugfunktion wird hierbei zum Ermitteln der Test-Steueranweisung passiv im Fahrzeug betrieben.

Nachteilhaft an diesem Verfahren ist, dass zur Verifizierung und/oder Validierung der Fahrzeugfunktion ein tatsächlicher Betrieb des Fahrzeugs zum Ermitteln der benötigten Daten erforderlich ist.

Die Hersteller von zumindest teilweise autonomen Verkehrsmitteln benötigen eine parallelisierte, simulationsbasierte Lösung. Die Testmethode "Szenario basiertes Testen" setzt hier an. Aber auch hier benötigt jedes zu testende Szenario Zeit und damit Kosten. Die Hersteller von zumindest teilweise autonomen Verkehrsmitteln besitzen Datenbanken mit Tausenden von Szenarien, in denen sich im Laufe der Zeit Duplikate oder sehr ähnliche Szenarien häufen. Selbst bei einer massiven Parallelisierung ist das Testen aller Szenarien zu zeitaufwändig. In einer vorteilhaften Ausgestaltung der Erfindung werden doppelte und ähnliche Szenarien identifiziert und so eine Ausführungsreihenfolge bestimmt, die zur Maximierung der Abdeckung der Szenarien beiträgt.

Die WO2017/210222 A1 offenbart ein Verfahren zum Generieren von Simulationsszenarien für autonome Fahrzeuge, die anhand von vielen aufgenommene Szenarien erweitert werden. Dies wird durch das Erkennen von Ähnlichkeiten und Unterschieden gewährleistet.

Es ist daher Aufgabe der Erfindung, ein Verfahren, eine Testeinheit, ein Computerprogramm und einen computerlesbaren Datenträger anzugeben, welche eine Ausführungsreihenfolge von Szenarien im Rahmen eines Szenario-basierten Testens für Systeme und Systemkomponenten im hochautomatisierten Fahren in effizienter Weise ermitteln können.

### Offenbarung der Erfindung

Die Aufgabe wird erfindungsgemäß gelöst durch ein computerimplementiertes Verfahren zum Bereitstellen eines Szenario-Test-Verlaufs zu testender Verkehrsszenarien für Tests einer Vorrichtung zur zumindest teilweisen autonomen Führung eines Verkehrsmittels nach Patentanspruch 1, eine Testeinheit, für die ein Test-Verlauf von zu testender Verkehrsszenarien ausgeführt wird nach Patentanspruch 12, ein Computerprogramm nach Patentanspruch 14 und einen computerlesbaren Datenträger nach Patentanspruch 15.

Beim Szenario-basierten Testen von Systemen und Systemkomponenten zur autonomen Führung eines Kraftfahrzeugs werden Szenarien definiert, welche als Abstraktion einer Verkehrssituation bezeichnet werden können. Für jedes Szenario können dann wiederum Testfälle ausgeführt werden. Ein logisches Szenario ist hierbei die Abstraktion einer Verkehrssituation mit der Straße, dem Fahrverhalten und dem umliegenden Verkehr ohne konkrete Parameterwerte. Durch die Wahl konkreter Parameterwerte wird aus dem logischen Szenario ein konkretes Szenario. Ein solches konkretes Szenario entspricht einer jeweils einzelnen Verkehrssituation.

Für Parametersätze können zwischen Szenerie-Parametern und Fahrsituationsparametern unterschieden werden, wobei alle Parameter einen vorgegebenen Definitionsbereich aufweisen.

Im Sinne der Szenerie-Parameter können zum Beispiel Straße mit verschiedenen Fahrspurmarkierungen, verschiedene Landschaften, Kreuzungen, Kurven und Straßenbeschränkungen eine Herausforderung sein. Darüber hinaus können Fahrsituationsparameter durch die Anzahl und Art der Verkehrsteilnehmer bestimmt werden. Fahrsituationsparameter spiegeln damit bewegliche Objekte im Szenario wider, wie die Anzahl der Verkehrsteilnehmer, Art der Verkehrsteilnehmer, Anzahl Spurwechsel und / oder durchgeführte Manöver der Verkehrsteilnehmer.

Eine autonome Fahrfunktion ist durch ein System, beispielsweise ein Steuergerät, realisiert. Das Steuergerät wird herkömmlicherweise im realen Fahrzeug in realen Verkehrssituationen getestet, durch Hardware-in-the-loop Tests oder alternativ durch vollständig virtuelle Tests validiert.

Das Verfahren umfasst des Weiteren Trainieren und Verwenden eines Ähnlichkeitsklassifikationsmoduls zur Klassifizierung der Ähnlichkeit zwischen zwei Szenarien basierend auf einer Teilmenge eines Parametersatzes des jeweiligen Szenarios.

Die Teilmenge eines Parametersatzes ist durch eine Szenario-Vektorrepräsentation gegeben. Die Szenario-Vektorrepräsentationen enthält differenzierende, statische Variablen eines Parametersatzes eines Szenarios, umfassend Szenerie-Parameter und Fahrsituationsparameter, die die Unterscheidbarkeit von realen Verkehrssituationen erlauben.

Jedes strukturierte, maschinenlesbare Datenobjekt, das ein Szenario darstellt, enthält Tausende von Eigenschaften. Einige der Eigenschaften sind nicht erforderlich, um redundante Szenarien zu erkennen. Zum Beispiel die Startposition des Straßennetzes innerhalb des Koordinatensystems eines Szenarios ist für die Feststellung, ob das autonome Fahren ordnungsgemäß funktioniert, unerheblich. Im Gegensatz dazu ist die Anzahl der Spuren für das Testen von Steuergeräten wichtig, da zusätzliche Fahrspuren für Ausweichmanöver verwendet werden können. Des Weiteren ist das Fehlen einer weiteren Fahrspur fatal, wenn das Steuergerät ein Ausweichmanöver durchführt.

Daher wird erfindungsgemäß, wesentliche Merkmale, die ein Szenario darstellen, in einer Vektorrepräsentation zusammengeführt und als Eingabe für das Ähnlichkeitsklassifikationsmodul verwendet.

Im Rahmen des vorliegenden Verfahrens wird demnach in vorteilhafter Weise ein Maschinelles Lernverfahren und Modell eingesetzt, wie vorzugsweise ein Perzeptron, ein künstliches neuronales Netz, Support Vector Machines und / oder Reinforcement Learning, welche zur Aufgabe haben, die Ähnlichkeit zwischen Szenarien, dargestellt in einer Szenario-Vektorrepräsentation, zu ermitteln.

Das Perzeptron ist ein vereinfachtes künstliches neuronales Netz, welches aus einem einzelnen künstlichen Neuron mit anpassbaren Gewichtungen und einem Schwellenwert besteht. Das vorliegende Verfahren nutzt zur Realisierung einer Ähnlichkeitsaussage durch ein Perzeptron ein Tripel-Ansatz. Es werden Trainingsdaten durch Experten zur Verfügung gestellt, die eine Aussage erlauben ob Szenario S2 ähnlicher zu S1 ist als Szenario S3. Entsprechend wird ein Feedback zur Gewichtung zurück gegeben in der Höhe von 1 oder -1, so dass das Perzeptron durch ein überwachtes Lernverfahren Gewichte anpassen und lernen kann, Ähnlichkeiten zwischen Szenarien zu erkennen und dann selbständig Ähnlichkeitsaussagen treffen kann.

Das vorliegende Verfahren kann des Weiteren die Ähnlichkeit zwischen zwei Szenarien unter Verwendung eines künstlichen neuronalen Netzes bestimmen. Das vorliegende Verfahren kann unter Verwendung eines künstlichen neuronalen Netzes zur Identifikation von Ähnlichkeiten zwischen Szenarien ein bestärkendes und / oder ein überwachtes Lernverfahren einsetzen. Im Unterschied zum bestärkenden Lernen unter Verwendung eines künstlichen neuronalen Netzes wird beim überwachten Lernen mit gegebenen Trainingsdaten trainiert. Trainingsdaten können hier durch bereits existierende Simulationsergebnisse oder bewerteter Ähnlichkeit zwischen Szenarien durch Experten gegeben sein.

Stattdessen existieren beim bestärkenden Lernen zwei Parteien: Das Netz, allgemein als Agent bezeichnet, und die Umgebung. Die Umgebung kann auch als Spielfeld angesehen werden, an dem der aktuelle Zustand bzw. die aktuelle Position des Agenten abgelesen wird. Das Netz führt auf Basis des aktuellen Zustands eine Aktion aus. Diese Aktion verändert den Zustand der Umgebung. Von der Umgebung bekommt das Netz den neuen Zustand und eine Bewertung der getätigten Aktion zurück.

Ziel ist es, die bestmögliche Bewertung zu erreichen, also die Bewertung zu maximieren. Folglich werden im Lernprozess anhand der Bewertung des getätigten Zuges die Gewichte des neuronalen Netzes angepasst und es wird eine neue Aktion durchgeführt. Durch die sukzessive Anpassung der Gewichte lernt das Netz die bestmögliche Aktion durchzuführen, also eine Strategie, die bestmögliche Bewertung zu erlangen. Analog kann durch einfache Anpassung die Bewertung auch minimiert werden, falls ein Minimum erreicht werden soll.

Neben der Anwendung von bestärkendem Lernen unter Verwendung von künstlichen neuronalen Netzen, können im Sinne des Reinforcement Learnings auch andere Methoden wie Monte-Carlo und / oder Temporal-Difference Learning eingesetzt werden.

Support Vector Machine ist ein Verfahren der Mustererkennung, das in Computerprogrammen umgesetzt wird und so entsprechend des vorliegenden Verfahrens die Ähnlichkeit zwischen Szenarien indiziert. Dazu wird eine Menge von Trainingsobjekten benötigt, die durch Experten vorklassifiziert sein können oder durch existierende Simulationsergebnisse vorhergehender Tests vorliegen. Jedes Objekt wird im Sinne der Support Vector Machines durch einen Vektor in einem Vektorraum repräsentiert. Erfindungsgemäß werden Szenarien als Szenario-Vektorrepräsentationen beschrieben. Aufgabe der Support Vector Machine ist es, in diesen Raum mindestens eine Hyperebene zu legen, die die Objekte in mindestens zwei Klassen teilt. Darüber werden ähnliche Szenario-Vektorrepräsentationen bestimmt.

Damit nicht unnötig viele Verkehrssituationen und damit Parametersätze über herkömmliche Simulationsverfahren getestet werden müssen, werden im Rahmen des vorliegenden Verfahrens die Ähnlichkeit zwischen Szenarien ermittelt durch das Ähnlichkeitsklassifikationsmoduls, so dass sehr ähnliche Parameterkombinationen erkannt und nicht doppelt validiert werden.

Das Ergebnis des Ähnlichkeitsklassifikationsmoduls für zwei Szenarien wird durch den Ähnlichkeitsklassifikationswert, der vorzugsweise in einem numerischen Wertebereich zwischen 0 und 1 liegt angegeben, wobei 0 keine Ähnlichkeit zwischen den Szenarien indiziert und 1 eine vollständige Übereinstimmung bezogen auf die jeweiligen Szenario-Vektorrepräsentationen, also der Teilmenge eines Parametersatzes. In anderen Ausführungsformen kann der Ähnlichkeitsklassifikationswert auch in anderen Skalengrößen angegeben werden.

Alle Szenarien-Vektorrepräsentationen und jeweilige Ähnlichkeitsklassifikationswerte werden in einer Speichereinheit gespeichert, die dafür ausgebildet ist, die Zusammenhänge zwischen den Vektoren und Ähnlichkeiten nachzuhalten.

Zur Bestimmung einer geeigneten Ausführungsreihenfolge, die möglichst abweichende Szenarien beinhaltet, wird eine Graphen-Repräsentation umfassend einer Vielzahl von Szenarien erzeugt, vorzugsweise alle Szenarien-Vektorrepräsentationen in der Speichereinheit. In der Graphen-Repräsentation stellen die Knoten die Szenario-Vektorrepräsentationen dar, also eine Teilmenge des Parametersatzes des Szenarios und Kanten zwischen zwei Knoten werden mit dem Ähnlichkeitsklassifikationswert gewichtet, so dass die Ähnlichkeit zwischen zwei Knoten und damit die repräsentierenden Szenarien indiziert wird.

Durch Erhalten einer Benutzereingabe durch eine elektronische Benutzerschnittstelle und / oder einer automatischen Systemeingabe, wobei die Eingabe einen geforderten Wert für die Abdeckung der in der Speichereinheit gespeicherten Szenarien beinhaltet und / oder eine geforderte Anzahl an zu testenden Szenarien, so dass eine Zielsetzung für das Verfahren bestimmt wird. Es wird dann eine Auswahl und Ausführungsreihenfolge der Szenarien und damit der repräsentierenden Knoten mit der Zielsetzung einer maximalen Abdeckung des Graphen bestimmt entsprechend der gegebenen Eingabe. Sollte eine Gesamtabdeckung von zumindest 70% der gespeicherten Szenarien und damit realen Verkehrssituationen erforderlich sein, wird eine Auswahl und Ausführungsreihenfolge bis zu diesem Schwellwert bestimmt. Es sind natürlich andere Ausführungsbeispiele mit anderen Eingaben zu einer Gesamtabdeckung möglich. Wird durch die Eingabe eine maximale Anzahl an Szenarien angegeben, werden die Szenarien ausgewählt und die Ausführungsreihenfolge bestimmt, die einer optimalen Abdeckung, im Rahmen des begrenzenden Schwellwerts, entspricht. Das erfindungsgemäße Verfahren kann somit Ergebnisse in Relation zu zur Verfügung stehenden Ressourcen liefern.

Zur Auswahl eines nächsten Knoten und damit das repräsentierende Szenario, also der Teilmenge eines Parametersatzes eines Szenarios, kann vorzugsweise ein gieriger Algorithmus verwendet werden. Solche Algorithmen zeichnen sich dadurch aus, dass sie schrittweise den Folgezustand auswählen, der zum Zeitpunkt der Wahl den größten Gewinn bzw. das beste Ergebnis verspricht, wobei sich hier das Ergebnis durch eine möglichst großer Abdeckung an Szenarien, basierend auf der Eingabe durch den Benutzer oder einer zuvor bestimmten Systemeingabe, bildet.

Unter Verwendung des vorliegenden Verfahrens kann beispielsweise ein sogenanntes Cut-In-Szenario von anderen Szenarien unterschieden werden. Das Cut-In-Szenario kann als Verkehrssituation bezeichnet werden, bei welcher ein hochautomatisiertes bzw. autonomes Fahrzeug in einer vorgegebenen Fahrspur fährt und ein anderes Fahrzeug mit gegenüber dem Ego-Fahrzeug verringerter Geschwindigkeit von einer weiteren Fahrspur in die Fahrspur des Ego-Fahrzeugs in einem bestimmten Abstand einschert. Das Ego-Fahrzeug bezeichnet hier das zu testende Fahrzeug.

Die Geschwindigkeit des Ego-Fahrzeugs und des weiteren Fahrzeugs, welches auch als Fellow-Fahrzeug bezeichnet wird, ist dabei konstant. Da die Geschwindigkeit des Ego-Fahrzeugs höher ist als die des Fellows, muss das Ego-Fahrzeug abgebremst werden, um eine Kollision der beiden Fahrzeuge zu vermeiden. Aber auch ein Cut-in-Szenario kann in verschiedenen Ausprägungsformen vorliegen, wie eine Unterscheidung in der Fahrbahnbreite, oder der Anzahl an Fahrspuren.

Die gemäß des Verfahrens gewählten Szenarien, in der definierten Ausführungsreihenfolge können anschließend in vorteilhafter Weise im Rahmen von virtuellen Tests des Steuergeräts validiert werden, sodass durch das erfindungsgemäße Verfahren ein effizienteres virtuelles Validieren von Steuergeräten zur autonomen Führung von Verkehrsmitteln möglich ist.

Im Rahmen der Tests einer Vorrichtung zur zumindest teilweisen autonomen Führung eines Verkehrsmittels basierend auf der Ausführungsreihenfolge der Szenarien können dann auch dynamische Variablen eines Parametersatzes, die nicht Teil der Szenario-Vektorrepräsentation sind variiert und getestet werden, inklusive der Geschwindigkeit eines Verkehrsteilnehmers.

Weitere Ausführungsformen der vorliegenden Erfindung sind Gegenstand der weiteren Unteransprüche und der nachfolgenden Beschreibung unter Bezugnahme auf die Figuren.

Die Testeinheit umfasst Mittel zum Bereitstellen eines Test-Verlaufs zu testender Verkehrsszenarien, für Tests einer Vorrichtung zur zumindest teilweisen autonomen Führung eines Verkehrsmittels.

Die Testeinheit ist somit in vorteilhafter Weise in der Lage, entsprechende Szenarien für Tests in geeigneter Ausführungsreihenfolge im Hinblick auf beispielsweise ein Cut-In-Szenario zu ermitteln.

Gemäß einem weiteren Aspekt der Erfindung ist ferner ein Computerprogramm mit Programmcode vorgesehen, um das erfindungsgemäße Verfahren durchzuführen, wenn das Computerprogramm auf einem Computer ausgeführt wird. Gemäß einem weiteren Aspekt der Erfindung ist ein Datenträger mit Programmcode eines Computerprogramms vorgesehen, um das erfindungsgemäße Verfahren durchzuführen, wenn das Computerprogramm auf einem Computer ausgeführt wird.

Die hierin beschriebenen Merkmale des Verfahrens sind zur Identifikation eines Test-Verlaufs einer Vielzahl unterschiedlicher Szenarien bzw. Fahrsituationen verwendbar. Ebenfalls ist die erfindungsgemäße Testeinheit dazu geeignet, eine Vielzahl unterschiedlicher Vorrichtungen bzw. Steuergeräte von z.B. Automobilen, Nutzfahrzeugen und/oder kommerziellen Fahrzeugen, Schiffen oder Flugzeugen im Sinne einer Durchführung eines Test-Verlaufs einer Vielzahl unterschiedlicher Szenarien bzw. Fahrsituationen zu testen.

### Kurze Beschreibung der Zeichnungen

Zum besseren Verständnis der vorliegenden Erfindung und ihrer Vorteile wird nun auf die nachfolgende Beschreibung in Verbindung mit den zugehörigen Zeichnungen verwiesen. Nachfolgend wird die Erfindung anhand exemplarischer Ausführungsformen näher erläutert, die in den schematischen Abbildungen der Zeichnungen angegeben sind.

Es zeigen:
- Figur 1: zeigt eine schematische Darstellung von der erfindungsgemäßen Unterscheidung der Teilmenge eines Parametersatzes eines Szenarios,
- Figur 2: zeigt eine schematische Darstellung zur erfindungsgemäßen Unterscheidung von Szenarien,
- Figur 3: zeigt ein Ablaufdiagramm zum Trainieren und Verwenden eines Ähnlichkeitsklassifikationsmoduls zur Klassifizierung der Ähnlichkeit zwischen zwei Szenarien, als Teil des Verfahrens zum Bereitstellen eines Test-Verlaufs zu testender Verkehrsszenarien für Tests einer Vorrichtung zur zumindest teilweisen autonomen Führung eines Verkehrsmittels gemäß einer bevorzugten Ausführungsform der Erfindung.
- Figur 4: zeigt eine erfindungsgemäße Ausführungsform zur Erzeugung von Tripel Trainingsdaten für ein Ähnlichkeitsklassifikationsmodul zur Klassifizierung der Ähnlichkeit zwischen zwei Szenarien, als Teil des Verfahrens zum Bereitstellen eines Test-Verlaufs zu testender Verkehrsszenarien für Tests einer Vorrichtung zur zumindest teilweisen autonomen Führung eines Verkehrsmittels,
- Figur 5: zeigt eine Abbildung einer erfindungsgemäßen Graphen-Repräsentation ohne Wahl eines Knoten und damit des repräsentierenden Szenarios,
- Figur 6: zeigt eine Abbildung einer erfindungsgemäßen Graphen-Repräsentation nach der ersten Wahl eines Knoten und damit des repräsentierenden Szenarios,
- Figur 7: zeigt eine Abbildung einer erfindungsgemäßen Graphen-Repräsentation nach einer weiteren Wahl eines Knoten und damit des repräsentierenden Szenarios,
- Figur 8: zeigt eine weitere vorteilhafte Ausführungsform einer Graphen-Repräsentation und der Bestimmung von Abdeckungswerten nach der Wahl eines Knoten und damit das repräsentierende Szenario,
- Figur 9: zeigt eine Abbildung des erfindungsgemäßen Verfahrens zur Bestimmung eines Test-Verlaufs zu testender Verkehrsszenarien, für Tests einer Vorrichtung zur zumindest teilweisen autonomen Führung eines Verkehrsmittels.

### Ausführliche Beschreibung der Ausführungsformen

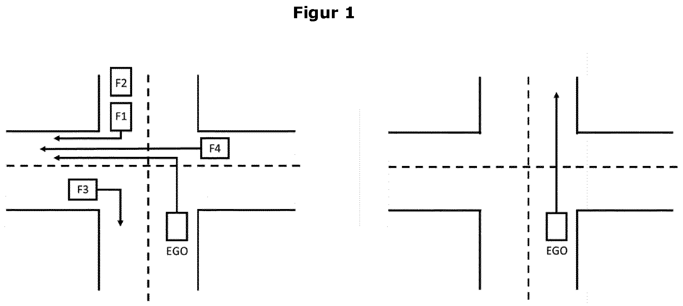

Figur 1 zeigt eine schematische Darstellung von der erfindungsgemäßen Unterscheidung der Teilmenge eines Parametersatzes (SVR) eines Szenarios (S₁ bis Sₙ). In Figur 1 ist dazu beispielhaft ein Kreuzungsszenario dargestellt mit abweichender Anzahl an Fellow-Fahrzeugen. Im ersten Szenario S₁ in Figur 1 wird ein Linksabbiege-Manöver des Ego-Fahrzeug gezeigt, mit 4 Fellow-Fahrzeugen, die ebenfalls den Kreuzungsbereich durchfahren. Im zweiten Szenario S₂ in Figur 1 durchfährt das Ego Fahrzeug gradlinig den Kreuzungsbereich ohne Einwirkung von Fellow-Fahrzeugen. Trotz gleichbleibender Straßenarchitektur, Randbebauung und Kurven, unterscheiden die vorliegenden Szenarien S₁ und S₂ sich deutlich, so dass eine abweichende Teilmenge eines Parametersatzes identifiziert wird und so abweichende Werte für die Szenario-Vektorrepräsentationen (SVR) erzeugt werden, der sich direkt auf die realen Verkehrssituationen bezieht. In der Szenario-Vektorrepräsentation (SVR) würden Werte für z.B. Randbebauung, Kurven gleiche Werte erhalten, aber für die Anzahl an Fellow-Fahrzeugen würden abweichende Werte definiert. Abschließend wird ein niedrigerer Ähnlichkeitsklassifikationswert (SCV) zwischen den Szenarien S₁ und S₂ auf Basis ihrer Szenario-Vektorrepräsentation (SVR) ermittelt.

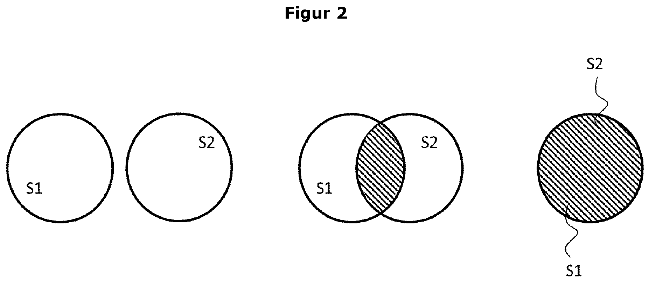

Figur 2 zeigt eine schematische Darstellung zur erfindungsgemäßen Unterscheidung von Szenarien (S₁ bis Sₙ). Es können gemäß der Figur 2 die Szenarien S₁ und S₂ vollständig abweichend sein bezogen auf der Teilmenge ihres Parametersatzes, überlappende Parameter aufweisen oder auch bezogen auf der Teilmenge ihres jeweiligen Parametersatzes gleich sein.

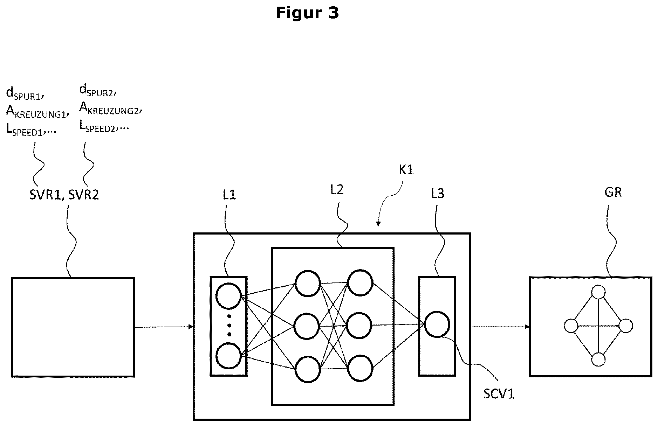

Figur 3 zeigt ein Ablaufdiagramm zum Trainieren und Verwenden eines Ähnlichkeitsklassifikationsmoduls (SCM) zur Klassifizierung der Ähnlichkeit zwischen zwei Szenarien, als Teil des Verfahrens zum Bereitstellen eines Test-Verlaufs zu testender Verkehrsszenarien für Tests einer Vorrichtung zur zumindest teilweisen autonomen Führung eines Verkehrsmittels gemäß einer bevorzugten Ausführungsform der Erfindung.

Das in Figur 3 dargestellte künstliche neuronale Netz K1 weist eine Eingabeschicht L1, eine Mehrzahl versteckter Schichten L2 und eine Ausgabeschicht L3 auf. Die Ausgabe des künstlichen neuronalen Netzes K1 ist ein Ähnlichkeitsklassifikationswert (SCV). Der Ähnlichkeitsklassifikationswert (SVC) liegt in einer erfindungsgemäßen Ausführung in einem numerischen Wertebereich zwischen 0 und 1, wobei 0 eine vollständige Abweichung zwischen den Szenarien angibt und 1 eine Übereinstimmung bezogen auf der Teilmenge des Parametersatzes, der Szenario-Vektorrepräsentation (SVR).

Zum Trainieren des künstlichen neuronalen Netzes K1 können bereits zumindest 1 klassifiziertes Wertepaar einer Teilmenge eines Parametersatzes SVR₁ und SVR₂ und damit dem Ähnlichkeitsklassifikationswert SCV_{(S1,S2)} oder auch Tripel von bereits klassifizierten Teilmengen eines Parametersatzes (SVR₁, SVR₂, SVR₃) genutzt werden. Alternativ können die Mehrzahl von Teilmengen von Parametersätzen SVR₁, SVR₂, ..., SVRₙ und der entsprechenden Ähnlichkeitsklassifikationswerte SCV_{(S1,S2)} bis SCV_{(Sn,Sm)} beispielsweise durch eine Simulation erzeugt werden.

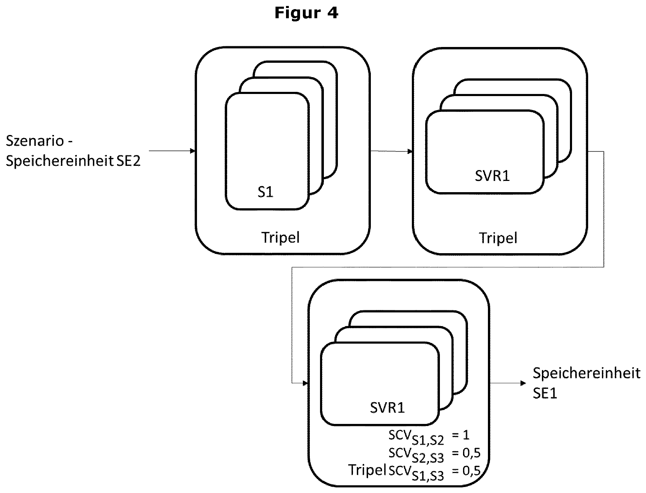

Figur 4 zeigt eine erfindungsgemäße Ausführungsform zur Erzeugung von Tripel-Trainingsdaten für ein Ähnlichkeitsklassifikationsmodul (SCM) zur Klassifizierung der Ähnlichkeit zwischen zwei Szenarien, als Teil des Verfahrens zum Bereitstellen eines Test-Verlaufs zu testender Verkehrsszenarien für Tests einer Vorrichtung zur zumindest teilweisen autonomen Führung eines Verkehrsmittels.

Dazu werden gemäß Figur 4 drei Szenarien S₁ bis S₃ aus einer weiteren Speichereinheit (SE₂) ausgewählt. Für die Szenarien werden die Szenario-Vektorrepräsentationen SVR₁ bis SVR₃ erstellt. Für dieses Tripel werden dann Ähnlichkeitsklassifikationswerte (SCV) ermittelt, vorzugsweise durch Experten oder Simulationsergebnisse aus bereits erstellten Simulationen zum Testen einer Vorrichtung zur zumindest teilweisen autonomen Führung eines Verkehrsmittels. Diese Tripel können dann als Eingabe Trainingsdaten für Maschinelle Lernverfahren und Modelle, wie erfindungsgemäß einem Perzeptron, einem neuronalen Netz, Reinforcement Learning und / oder Support Vector Machines genutzt werden.

Alle Szenarien-Vektorrepräsentationen (SVC) und jeweilige Ähnlichkeitsklassifikationswerte (SCV) werden in einer geeigneten Speichereinheit (SE₁) gespeichert, die dafür ausgebildet ist, die Zusammenhänge zwischen den Vektoren und Ähnlichkeiten nachzuhalten.

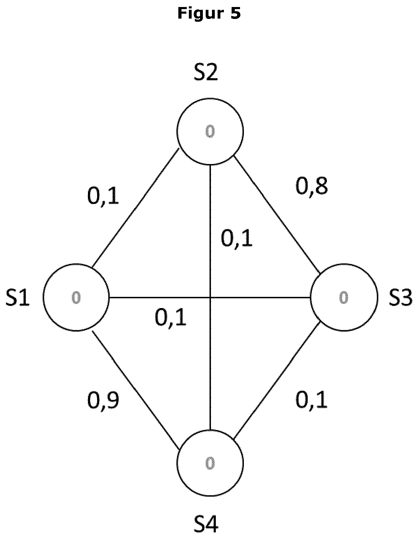

Figur 5 zeigt eine Abbildung einer erfindungsgemäßen Graphen-Repräsentation (GR) ohne Wahl eines ersten Knotens. Das Erzeugen einer Graphen-Repräsentation (GR) umfasst eine Vielzahl von Szenarien, dessen Teilmenge von Parametersätzen, demnach einer Szenario-Vektorrepräsentation, die in einer geeigneten Speichereinheit (SE₁) gespeichert sind. In der Graphen-Repräsentation (GR) stellen Knoten jeweils die Teilmenge eines Parametersatzes eines Szenarios dar und Kanten zwischen zwei Knoten sind mit einem Ähnlichkeitsklassifikationswert gewichtet, der die Ähnlichkeit zwischen den zwei Szenarien, der jeweiligen Knoten indiziert.

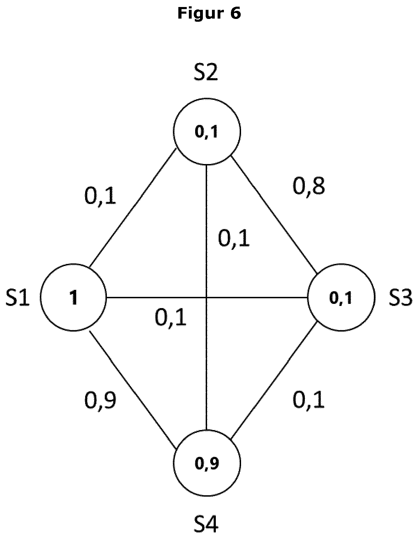

Figur 6 zeigt eine Abbildung einer erfindungsgemäßen Graphen-Repräsentation nach der ersten Wahl eines Knoten. In Figur 6 wurde beispielhaft Knoten und damit das repräsentierende Szenario S₁ gewählt. In diesem Knoten liegt dann ein Abdeckungswert (CV) mit dem numerischen Wert 1 vor. Die anderen Knoten und damit repräsentierenden Szenarien S₂ bis S₄ erhalten einen Abdeckungswert (CV) des Ähnlichkeitsklassifikationswertes (SCV) zu S₁.

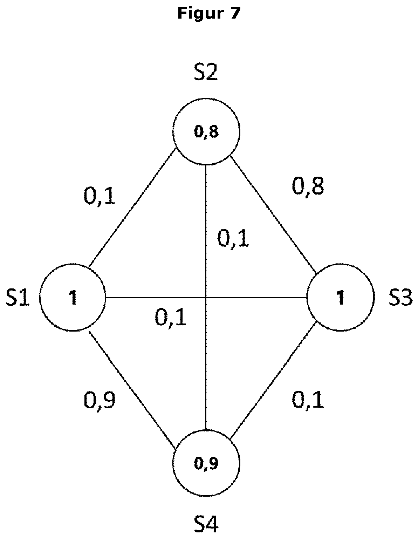

Figur 7 zeigt eine Abbildung einer erfindungsgemäßen Graphen-Repräsentation nach einer weiteren Wahl eines Knoten. Gemäß Figur 7 wurde beispielhaft Knoten und damit das repräsentierende Verkehrsszenario S₃ gewählt. Auch dieser Knoten erhält mit diesem Schritt den Abdeckungswert (CV) 1. Die weiteren Knoten und damit repräsentierende Szenarien erhalten den numerischen Wert der maximalen Ähnlichkeit in Bezug zum Ähnlichkeitsklassifikationswert (SCV) zu den Knoten S₁ oder S₃, je nach dem welcher numerischer Wert höher ist.

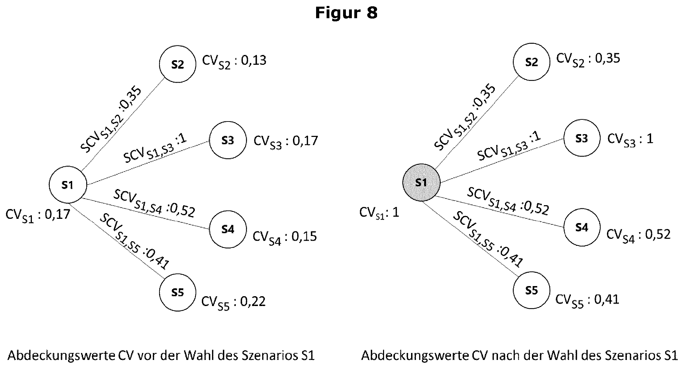

Figur 8 zeigt eine weitere vorteilhafte Ausführungsform einer Graphen-Repräsentation (GR) und der Bestimmung von Abdeckungswerten (CV) nach der Wahl eines Knoten und damit das repräsentierende Szenario.

Die Graphen-Repräsentation (GR) in Figur 8 weist 5 Knoten und damit repräsentierende Szenarien S₁-S₅, also reale Verkehrssituationen auf. Für alle Knoten wurde bereits ein erster Abdeckungswert (CV) und ein Ähnlichkeitsklassifikationswert (SCV) bestimmt. Nach Wahl des Knoten und damit Szenarios S₁ wurden die entsprechenden Abdeckungswerte (CV) erneuert und zeigen jeweils einen Abdeckungswert (CV) des maximalen Ähnlichkeitsklassifikationswertes (SCV) zu S₁ auf. Durch den Ähnlichkeitsklassifikationswert des numerischen Wertes von 1 kann von einer vollständigen Abdeckung von S₃ nach der Wahl von S₁ ausgegangen werden bezogen auf ihre jeweiligen Szenario-Vektorrepräsentationen (SVR).

In dieser besonderen und vorteilhaften Ausführungsform in Figur 8 wurde die Graphen-Repräsentation (GR) gezielt dazu verwendet Übereinstimmungen und damit Ähnlichkeitswerte (SCV) von einem Verkehrsszenario S₁ zu anderen Szenarien zu bestimmen und damit zu untersuchen in wie weit das Szenario S₁ redundante Tests beinhaltet im Vergleich zu den weiteren Szenarien S₂-S₅. Darüber kann auch eine Gewichtung von Szenarien vorgesehen werden.

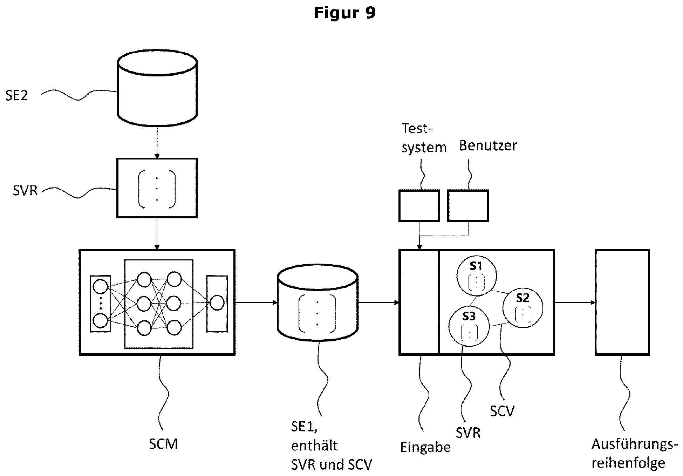

Figur 9 zeigt eine Abbildung des erfindungsgemäßen Verfahrens zur Bestimmung eines Test-Verlaufs zu testender Verkehrsszenarien, für Tests einer Vorrichtung zur zumindest teilweisen autonomen Führung eines Verkehrsmittels.

In der Figur 9 sind zunächst in Speichereinheit SE2, die auch durch Messdaten repräsentierten Szenarien festgehalten, die in hoher Stückzahl bei Herstellern von zumindest teilweise autonomen Fahrzeugen vorliegen. Auf Basis der Szenarien in Speichereinheit SE2 werden Szenario-Vektorrepräsentationen (SVR) erzeugt. Diese Szenario-Vektorrepräsentationen (SVR) sind Eingabe für das Ähnlichkeitsklassifikationsmoduls (SCM). Die ermittelten Ähnlichkeitsklassifikationswerte (SCV) durch das Ähnlichkeitsklassifikationsmodul werden in Zusammenhang mit den entsprechenden Szenario-Vektorrepräsentationen (SVR)in der Speichereinheit SE1 gespeichert. Die Einträge aus Speichereinheit SE1 werden dann als Eingabe für die Graphen-Repräsentation (GR) genutzt. Die Graphen-Repräsentation (GR) ermittelt Abdeckungswerte (CV) und darüber eine Ausführungsreihenfolge der Szenarien-Vektorrepräsentationen.

Die beanspruchte Erfindung wird durch die folgenden Ansprüche definiert.

## Patentansprüche

1. Computerimplementiertes Verfahren zum Bereitstellen eines Szenario- Test-Verlaufs zu testenden Szenarien (S₁ bis Sₙ) insbesondere Verkehrsszenarien (S₁ bis Sₙ), für Tests einer Vorrichtung zur zumindest teilweisen autonomen Führung eines Verkehrsmittels mit den Schritten:
Trainieren und Verwenden eines
Ähnlichkeitsklassifikationsmoduls zur Klassifizierung der Ähnlichkeit zwischen zwei Szenarien (S₁ bis Sₙ) basierend auf einer Teilmenge eines Parametersatzes (SVR₁, SVR₂, SVR₃) des jeweiligen Szenarios (S₁ bis Sₙ), welches eine virtuelle Repräsentation einer reale Verkehrssituation darstellt;
Erzeugen einer Graphen-Repräsentation (GR) umfassend eine Vielzahl von Szenarien (S₁ bis Sₙ), umfassend die zwei Szenarien (S₁ bis Sₙ), deren Teilmenge von Parametersätzen in einer Speichereinheit (SE_{1,} SE₂) gespeichert sind, wobei Knoten jeweils die Teilmenge eines Parametersatzes (SVR₁, SVR₂, SVR₃) eines Szenarios (S₁ bis Sₙ) repräsentieren und Kanten zwischen zwei Knoten mit einem Ähnlichkeitsklassifikationswert (SCV) gewichtet sind, der die Ähnlichkeit zwischen den zwei Szenarien (S₁ bis Sₙ), der jeweiligen Knoten indiziert;
Erhalten einer Benutzereingabe durch eine elektronische Benutzerschnittstelle und / oder eine automatischen Systemeingabe, wobei die Eingabe einen geforderten Wert für eine Abdeckung, der in der Speichereinheit (SE_{1,} SE₂) gespeicherten Szenarien (S₁ bis Sₙ) beinhaltet und / oder eine geforderte Anzahl an zu testenden Szenarien (S₁ bis Sₙ), so dass eine Auswahl und Ausführungsreihenfolge der Szenarien (S₁ bis Sₙ) und der repräsentierenden Knoten mit der Zielsetzung einer maximalen Abdeckung des Graphen bestimmt wird, wobei eine Auswahl und Ausführungsreihenfolge bis zu einem Schwellwert entsprechend der gegebenen Eingabe bestimmt wird und/oder wobei die Ausführungsreihenfolge einer optimalen Abdeckung, im Rahmen des begrenzenden Schwellwerts, entspricht; und
Bereitstellen einer Auswahl und Ausführungsreihenfolge und / oder eines Abdeckungswerts (CV) einer GesamtAbdeckung der gewählten Knoten und damit der zu repräsentierenden Szenarien (S₁ bis Sₙ).

2. Computerimplementiertes Verfahren nach Anspruch 1, **dadurch gekennzeichnet, dass** ein Parametersatz beinhaltet:
Szenerie-Parameter umfassend zumindest eines der Merkmale: die Anzahl von und / oder die Breite eines Fahrstreifens und / oder Kurven und / oder Straßenbeschränkungen und / oder der Umgebungstemperatur und Fahrsituationsparameter, die die Anzahl und Eigenschaften beweglicher Objekte im Szenario (S₁ bis Sₙ) beschreiben, umfassend zumindest eines der Merkmale: die Anzahl von Verkehrsteilnehmer und / oder die Anzahl von Spurwechsel in einer Verkehrssituation.

3. Computerimplementiertes Verfahren nach einem der vorstehenden Ansprüche, **dadurch gekennzeichnet, dass** Szenarien (S₁ bis Sₙ), die eine virtuelle Repräsentation einer realen Verkehrssituation sind, durch eine Teilmenge des Parametersatzes (SVR₁, SVR₂, SVR₃) eines Szenarios (S₁ bis Sₙ), einer Szenario (S₁ bis Sₙ) -Vektorrepräsentation, beschrieben werden.

4. Computerimplementiertes Verfahren nach einem der vorhergehenden Ansprüche, **dadurch gekennzeichnet, dass** Szenario-Vektorrepräsentationen (SVR) differenzierende Variablen eines Parametersatzes (SVR₁, SVR₂, SVR₃) eines Szenarios (S₁ bis Sₙ) beinhalten, umfassend Szenerie-Parameter und Fahrsituationsparameter, die die Unterscheidbarkeit von realen Verkehrssituationen untereinander erlauben.

5. Computerimplementiertes Verfahren nach einem der vorstehenden Ansprüche, **dadurch gekennzeichnet, dass** die Szenario-Vektorrepräsentation (SVR) eines Verkehrsszenarios (S₁ bis Sₙ) in einer zentralen Speichereinrichtung gehalten wird und weniger Speicherkapazitäten benötigt als das nicht Vektorrepräsentierte Szenario (S₁ bis Sₙ).

6. Computerimplementiertes Verfahren nach einem der vorhergehenden Ansprüche, **dadurch gekennzeichnet, dass** Szenarien (S₁ bis Sₙ) eine Vielzahl von Tests einer Vorrichtung zur zumindest teilweisen autonomen Führung eines Verkehrsmittels umfassen, so dass in den Tests, dynamische Variablen eines Parametersatzes (SVR₁, SVR₂, SVR₃) variiert werden, insbesondere der Geschwindigkeit eines Verkehrsteilnehmers.

7. Computerimplementiertes Verfahren nach Anspruch 1 **dadurch gekennzeichnet, dass** das Ähnlichkeitsklassifikationsmodul zur Klassifizierung der Ähnlichkeit zwischen zwei Szenario-Vektorrepräsentationen (SVR) durch Maschinelle Lernverfahren und Modelle ausgebildet ist vorzugsweise durch ein Perzeptron und / oder einem neuronalen Netz (K1) und / oder Reinforcement Learning und / oder einer Support Vector Machine.

8. Computerimplementiertes Verfahren nach Anspruch 7, **dadurch gekennzeichnet, dass** Trainingsdaten für das Ähnlichkeitsklassifikationsmodul durch Experten und / oder Messergebnissen bereitgestellt werden und / oder durch vorherige Simulationsergebnisse, vorheriger Tests gegeben sind.

9. Computerimplementiertes Verfahren nach einem der vorhergehenden Ansprüche, **dadurch gekennzeichnet, dass** die Klassifikation der Ähnlichkeit von dem Ähnlichkeitsklassifikationsmodul in einem Ähnlichkeitsklassifikationswert (SCV) zwischen 0 und 1 wiedergegeben wird.

10. Computerimplementiertes Verfahren nach einem der vorhergehenden Ansprüche, **dadurch gekennzeichnet, dass** bei Auswahl eines ersten Knoten und damit das zu repräsentierende Szenario (S₁ bis Sₙ) in Form der Teilmenge eines Parametersatzes (SVR₁, SVR₂, SVR₃) im Graphen ein Abdeckungswert (CV) von 1 angegeben und für benachbarte Knoten im Graphen als Abdeckungswert (CV) der maximale Ähnlichkeitsklassifikationswert (SCV) zwischen dem ersten Knoten und den jeweilig benachbarten Knoten festgesetzt wird.

11. Computerimplementiertes Verfahren nach Anspruch 10, **dadurch gekennzeichnet, dass** für die Auswahl eines weiteren Knoten und damit das zu repräsentierende Szenario (S₁ bis Sₙ) immer nach maximaler möglicher Abdeckung entschieden wird.

12. Testeinheit zum Bereitstellen zum Bereitstellen eines Szenario-Test- Verlaufs zu testenden Szenarien (S₁ bis Sₙ) insbesondere Verkehrsszenarien (S₁ bis Sₙ), für Tests 20 einer Vorrichtung zur zumindest teilweisen autonomen Führung eines Verkehrsmittels mit den Schritten:
Trainieren und Verwenden eines Ähnlichkeitsklassifikationsmoduls zur Klassifizierung der Ähnlichkeit zwischen zwei Szenarien (S₁ bis Sₙ) basierend auf einer Teilmenge eines Parametersatzes (SVR₁, SVR₂, SVR₃) des jeweiligen Szenarios (S₁ bis Sₙ), welches eine virtuelle Repräsentation einer reale Verkehrssituation darstellt;
Erzeugen einer Graphen-Repräsentation (GR) umfassend eine Vielzahl von Szenarien (S₁ bis Sₙ), umfassend die zwei Szenarien (S₁ bis Sₙ), deren Teilmenge von Parametersätzen in einer Speichereinheit (SE_{1,} SE₂) gespeichert sind, wobei Knoten jeweils die Teilmenge eines Parametersatzes (SVR₁, SVR₂, SVR₃) eines Szenarios (S₁ bis Sₙ) repräsentieren und Kanten zwischen zwei Knoten mit einem Ähnlichkeitsklassifikationswert (SCV) gewichtet sind, der die Ähnlichkeit zwischen den zwei Szenarien (S₁ bis Sₙ), der jeweiligen Knoten indiziert;
Erhalten einer Benutzereingabe durch eine elektronische Benutzerschnittstelle und / oder eine automatischen Systemeingabe, wobei die Eingabe einen geforderten Wert für eine Abdeckung, der in der Speichereinheit (SE_{1,} SE₂) gespeicherten Szenarien (S₁ bis Sₙ) beinhaltet und / oder eine geforderte Anzahl an zu testenden Szenarien (S₁ bis Sₙ), so dass eine Auswahl und Ausführungsreihenfolge der Szenarien (S₁ bis Sₙ) und der repräsentierenden Knoten mit der Zielsetzung einer maximalen Abdeckung des Graphen bestimmt wird, wobei eine Auswahl und Ausführungsreihenfolge bis zu einem Schwellwert entsprechend der gegebenen Eingabe bestimmbar ist und/oder wobei die Ausführungsreihenfolge einer optimalen Abdeckung, im Rahmen des begrenzenden Schwellwerts, entspricht; und
Bereitstellen einer Auswahl und Ausführungsreihenfolge und / oder eines Abdeckungswerts (CV) einer GesamtAbdeckung der gewählten Knoten und damit der zu repräsentierenden Szenarien (S₁ bis Sₙ).

13. Testeinheit nach Anspruch 12, **dadurch gekennzeichnet, dass** die Vorrichtung durch ein Steuergerät ausgebildet ist, für welches Szenarien (S₁ bis Sₙ) für virtuelle und / oder reale Tests bestimmt wird.

14. Computerprogramm mit Programmcode, um das Verfahren nach einem der Ansprüche 1 bis 13 durchzuführen, wenn das Computerprogramm auf einem Computer ausgeführt wird.

15. Computerlesbarer Datenträger mit Programmcode eines Computerprogramms, um das Verfahren nach einem der Ansprüche 1 bis 13 durchzuführen, wenn das Computerprogramm auf einem Computer ausgeführt wird.

## Claims

1. A computer-implemented method for providing a scenario test procedure for scenarios (S₁ to Sₙ) to be tested, in particular traffic scenarios (S₁ to Sₙ), for testing a device for at least partially autonomously guiding a means of transport, comprising the steps:
training and using a similarity classification module for classifying the similarity between two scenarios (S₁ to Sₙ) based on a subset of a parameter set (SVR₁, SVR₂, SVR₃) of the respective scenario (S₁ to Sₙ) representing a virtual representation of a real traffic situation;
generating a graph representation (GR) comprising a plurality of scenarios (S₁ to Sₙ), comprising the two scenarios (S₁ to Sₙ) having the subset of parameter sets thereof stored in a storage unit **(SE_{1,} SE₂),** wherein nodes each represent the subset of a parameter set (SVR₁, SVR₂, SVR₃) of a scenario (S₁ to Sₙ) and edges between two nodes are weighted with a similarity classification value (SCV) indicating the similarity between the two scenarios (S₁ to Sₙ) of the respective nodes;
obtaining a user input via an electronic user interface and/or an automatic system input, wherein the input is a required value for a coverage comprising the scenarios (S₁ to Sₙ) stored in the storage unit **(SE_{1,} SE₂)** and/or a required number of scenarios (S₁ to Sₙ) to be tested, such that a selection and execution sequence of the scenarios (S₁ to Sₙ) and of the representing nodes is determined with the objective of maximizing coverage of the graph, wherein a selection and execution sequence is determined up to a threshold value corresponding to the given input and/or wherein the execution sequence corresponds to an optimal coverage, within the limiting threshold value; and
providing a selection and execution sequence and/or a coverage value (CV) of an overall coverage of the selected nodes and thus of the scenarios to be represented (S₁ to Sₙ).

2. The computer-implemented method according to claim 1, **characterized in that** a parameter set comprises:
scenario parameters comprising at least one of the features: the number of and/or the width of a lane and/or curves and/or road restrictions and/or the ambient temperature and driving situation parameters describing the number and properties of moving objects in the scenario (S₁ to Sₙ); comprising at least one of the features: the number of road users and/or the number of lane changes in a traffic situation.

3. The computer-implemented method according to any one of the preceding claims, **characterized in that** the scenarios (S₁ to Sₙ) are a virtual representation of a real traffic situation and are described by a subset of the parameter set (SVR₁, SVR₂, SVR₃) of a scenario (S₁ to Sₙ) or a scenario (S₁ to Sₙ) vector representation.

4. The computer-implemented method according to any one of the preceding claims, **characterized in that** scenario vector representations (SVR) contain differentiating variables of a parameter set (SVR₁, SVR₂, SVR₃) of a scenario (S₁ to Sₙ), comprising scenario parameters and driving situation parameters allowing real traffic situations to be distinguished from one another.

5. The computer-implemented method according to any one of the preceding claims, **characterized in that** the scenario vector representation (SVR) of a traffic scenario (S₁ to Sₙ) is held in a central storage device and requires less storage capacity than the non-vector-represented scenario (S₁ to Sₙ).

6. The computer-implemented method according to any one of the preceding claims, **characterized in that** the scenarios (S₁ to Sₙ) comprise a plurality of tests of a device for at least partially autonomously guiding a means of transport, so that dynamic variables of a parameter set (SVR₁, SVR₂, SVR₃) are varied in the tests, in particular the speed of a road user.

7. The computer-implemented method according to claim 1, **characterized in that** the similarity classification module for classifying the similarity between two scenario vector representations (SVR) is formed by machine learning methods and models, preferably by a perceptron and/or a neural network (K1) and/or reinforcement learning and/or a support vector machine.

8. The computer-implemented method according to claim 7, **characterized in that** training data for the similarity classification module are provided by experts and/or measurement results and/or are given by previous simulation results of previous tests.

9. The computer-implemented method according to any one of the preceding claims, **characterized in that** the classification of the similarity is represented by the similarity classification module in a similarity classification value (SCV) between 0 and 1.

10. The computer-implemented method according to any one of the preceding claims, **characterized in that** when selecting a first node and thus the scenario (S₁ to Sₙ) to be represented in the form of the subset of a parameter set (SVR₁, SVR₂, SVR₃) in the graph, a coverage value (CV) of 1 is specified, and the maximum similarity classification value (SCV) between the first node and the respective adjacent nodes is set as the coverage value (CV) for adjacent nodes in the graph.

11. The computer-implemented method according to claim 10, **characterized in that** the selection of a further node and thus the scenario (S₁ to Sₙ) to be represented is always decided according to maximum possible coverage.

12. A test unit for providing a scenario test procedure for scenarios (S₁ to Sₙ) to be tested, in particular traffic scenarios (S₁ to Sₙ), for testing a device for at least partially autonomously guiding a means of transport, comprising the steps:
training and using a similarity classification module for classifying the similarity between two scenarios (S₁ to Sₙ) based on a subset of a parameter set (SVR₁, SVR₂, SVR₃) of the respective scenario (S₁ to Sₙ) representing a virtual representation of a real traffic situation;
generating a graph representation (GR) comprising a plurality of scenarios (S₁ to Sₙ), comprising the two scenarios (S₁ to Sₙ) having the subset of parameter sets thereof stored in a storage unit (SE_{1,} SE₂), wherein nodes each represent the subset of a parameter set (SVR₁, SVR₂, SVR₃) of a scenario (S₁ to Sₙ) and edges between two nodes are weighted with a similarity classification value (SCV) indicating the similarity between the two scenarios (S₁ to Sₙ) of the respective nodes;
obtaining a user input via an electronic user interface and/or an automatic system input, wherein the input is a required value for a coverage of the scenarios (S₁ to Sₙ) stored in the storage unit (SE₁, SE₂) and/or a required number of scenarios (S₁ to Sₙ) to be tested, such that a selection and execution sequence of the scenarios (S₁ to Sₙ) and of the representing nodes is determined with the objective of maximizing coverage of the graph, wherein a selection and execution sequence can be determined up to a threshold value corresponding to the given input and/or wherein the execution sequence corresponds to an optimal coverage, within the limiting threshold value; and
providing a selection and execution sequence and/or a coverage value (CV) of an overall coverage of the selected nodes and thus of the scenarios to be represented (S₁ to Sₙ).

13. The test unit according to claim 12, **characterized in that** the device is formed by a control unit for which scenarios (S₁ to Sₙ) for virtual and/or real tests are determined.

14. A computer program having program code for performing the method according to any one of the claims 1 through 13 when the computer program is executed on a computer.

15. A computer-readable data carrier having program code of a computer program for performing the method according to any one of the claims 1 through 13 when the computer program is executed on a computer.

## Revendications

1. Procédé mis en œuvre par ordinateur pour la mise à disposition d'un déroulement de test de scénario pour des scénarios à tester (S₁ à Sₙ), en particulier des scénarios de trafic (S₁ à Sₙ), pour des tests d'un dispositif pour le guidage au moins partiellement autonome d'un moyen de transport, comprenant les étapes suivantes:
entraîner et utiliser un module de classification de similarité pour la classification de la similarité entre deux scénarios (S₁ à Sₙ) sur la base d'un sous-ensemble d'un ensemble de paramètres (SVR₁, SVR₂, SVR₃) du scénario respectif (S₁ à Sₙ), qui représente une représentation virtuelle d'une situation de trafic réelle;
générer une représentation en graphe (GR) comprenant une pluralité de scénarios (S₁ à Sₙ), comprenant les deux scénarios (S₁ à Sₙ) dont le sous-ensemble d'ensembles de paramètres est stocké dans une unité de stockage **(SE₁, SE₂),** des nœuds représentant chacun le sous-ensemble d'un ensemble de paramètres (SVR₁, SVR₂, SVR₃) d'un scénario (S₁ à Sₙ) et les arêtes entre deux nœuds étant pondérées par une valeur de classification de similarité (SCV) qui indique la similarité entre les deux scénarios (S₁ à Sₙ), des nœuds respectifs;
recevoir une saisie d'utilisateur par l'intermédiaire d'une interface utilisateur électronique et/ou d'une saisie système automatique, la saisie comprenant une valeur requise pour une couverture des scénarios (S₁ à Sₙ) stockés dans l'unité de stockage **(SE₁, SE₂)** et/ou un nombre requis de scénarios (S₁ à Sₙ) à tester, de sorte que sont déterminés une sélection et un ordre d'exécution des scénarios (S₁ à Sₙ) et des nœuds représentatifs avec l'objectif d'une couverture maximale du graphe, une sélection et un ordre d'exécution étant déterminés jusqu'à une valeur de seuil correspondant à la saisie donnée et/ou l'ordre d'exécution correspondant à une couverture optimale dans le cadre de la valeur de seuil limitative; et
fournir une sélection et un ordre d'exécution et/ou une valeur de couverture (CV) d'une couverture totale des nœuds sélectionnés et donc des scénarios à représenter (S₁ à Sₙ).

2. Procédé mis en œuvre par ordinateur selon la revendication 1, **caractérisé en ce qu'**un ensemble de paramètres comprend:
des paramètres environnementaux comprenant au moins l'une des caractéristiques: le nombre et/ou la largeur d'une voie de circulation et/ou des virages et/ou des restrictions routières et/ou la température ambiante et des paramètres de situation de conduite, qui décrivent le nombre et les propriétés d'objets mobiles dans le scénario (S₁ à Sₙ), comprenant au moins l'une des caractéristiques: le nombre d'usagers de la route et/ou le nombre de changements de voie dans une situation de trafic.

3. Procédé mis en œuvre par ordinateur selon l'une des revendications précédentes, **caractérisé en ce que** des scénarios (S₁ à Sₙ), qui sont une représentation virtuelle d'une situation de trafic réelle, sont décrits par un sous-ensemble de l'ensemble de paramètres (SVR₁, SVR₂, SVR₃) d'un scénario (S₁ à Sₙ) d'une représentation vectorielle de scénario (S₁ à Sₙ).

4. Procédé mis en œuvre par ordinateur selon l'une des revendications précédentes, **caractérisé en ce que** des représentations vectorielles de scénario (SVR) contiennent des variables différenciatrices d'un ensemble de paramètres (SVR₁, SVR₂, SVR₃) d'un scénario (S₁ à Sₙ), comprenant des paramètres environnementaux et des paramètres de situation de conduite, qui permettent la distinction de situations de trafic réelles entre elles.

5. Procédé mis en œuvre par ordinateur selon l'une des revendications précédentes, **caractérisé en ce que** la représentation vectorielle de scénario (SVR) d'un scénario de trafic (S₁ à Sₙ) est conservée dans un dispositif de stockage central et nécessite moins de capacités de stockage que le scénario (S₁ à Sₙ) non représenté par vecteur.

6. Procédé mis en œuvre par ordinateur selon l'une des revendications précédentes, **caractérisé en ce que** des scénarios (S₁ à Sₙ) comprennent une pluralité de tests d'un dispositif destiné au guidage au moins partiellement autonome d'un moyen de transport, de sorte que dans les tests, des variables dynamiques d'un ensemble de paramètres (SVR₁, SVR₂, SVR₃) sont variées, notamment de la vitesse d'un usager de la route.

7. Procédé mis en œuvre par ordinateur selon la revendication 1, **caractérisé en ce que** le module de classification de similarité est conçu pour classifier la similarité entre deux représentations vectorielles de scénario (SVR) par des procédés et modèles d'apprentissage automatique, de préférence par un perceptron et/ou un réseau neuronal (K1) et/ou un apprentissage par renforcement (Reinforcement Learning) et/ou une machine à vecteurs de support (Support Vector Machine).

8. Procédé mis en œuvre par ordinateur selon la revendication 7, **caractérisé en ce que** des données d'apprentissage pour le module de classification de similarité sont fournies par des experts et/ou des résultats de mesure et/ou sont données par des résultats de simulation de tests préalables.

9. Procédé mis en œuvre par ordinateur selon l'une des revendications précédentes, **caractérisé en ce que** la classification de la similarité par le module de classification de similarité est exprimée par une valeur de classification de similarité (SCV) comprise entre 0 et 1.

10. Procédé mis en œuvre par ordinateur selon l'une des revendications précédentes, **caractérisé en ce que**, lors de la sélection d'un premier nœud et donc du scénario (S₁ à Sₙ) à représenter sous la forme du sous-ensemble d'un ensemble de paramètres (SVR₁, SVR₂, SVR₃) dans le graphe, une valeur de couverture (CV) de 1 est indiquée et, pour des nœuds voisins dans le graphe, la valeur de classification de similarité maximale (SCV) entre le premier nœud et les nœuds voisins respectifs est fixée comme valeur de couverture (CV).

11. Procédé mis en œuvre par ordinateur selon la revendication 10, **caractérisé en ce que** pour la sélection d'un nœud supplémentaire et donc du scénario (S₁ à Sₙ) à représenter, la décision est toujours prise en fonction de la couverture maximale possible.

12. Unité de test pour la mise à disposition d'un déroulement de test de scénario pour des scénarios à tester (S₁ à Sₙ), en particulier des scénarios de trafic (S1 à Sn), pour des tests d'un dispositif destiné au guidage au moins partiellement autonome d'un moyen de transport, comprenant les étapes:
entraîner et utiliser un module de classification de similarité pour la classification de la similarité entre deux scénarios (S₁ à Sₙ) sur la base d'un sous-ensemble d'un ensemble de paramètres (SVR₁, SVR₂, SVR₃) du scénario respectif (S₁ à Sₙ), qui représente une représentation virtuelle d'une situation de trafic réelle;
générer une représentation en graphe (GR) comprenant une pluralité de scénarios (S₁ à Sₙ), comprenant les deux scénarios (S₁ à Sₙ) dont le sous-ensemble d'ensembles de paramètres est stocké dans une unité de stockage **(SE₁, SE₂),** des nœuds représentant chacun le sous-ensemble d'un ensemble de paramètres (SVR₁, SVR₂, SVR₃) d'un scénario (S₁ à Sₙ) et les arêtes entre deux nœuds étant pondérées par une valeur de classification de similarité (SCV) qui indique la similarité entre les deux scénarios (S₁ à Sₙ), des nœuds respectifs;
recevoir une saisie d'utilisateur par l'intermédiaire d'une interface utilisateur électronique et/ou d'une saisie système automatique, la saisie comprenant une valeur requise pour une couverture des scénarios (S₁ à Sₙ) stockés dans l'unité de stockage **(SE₁, SE₂)** et/ou un nombre requis de scénarios (S₁ à Sₙ) à tester, de sorte que soit déterminés une sélection et un ordre d'exécution des scénarios (S₁ à Sₙ) et des nœuds représentatifs avec l'objectif d'une couverture maximale du graphe, une sélection et un ordre d'exécution pouvant être déterminés jusqu'à une valeur de seuil correspondant à la saisie donnée et/ou l'ordre d'exécution correspondant à une couverture optimale dans le cadre de la valeur de seuil limitative; et
fournir une sélection et un ordre d'exécution et/ou une valeur de couverture (CV) d'une couverture totale des nœuds sélectionnés et donc des scénarios à représenter (S₁ à Sₙ).

13. Unité de test selon la revendication 12, **caractérisée en ce que** le dispositif est formé par un appareil de commande pour lequel des scénarios (S₁ à Sₙ) sont déterminés pour des tests virtuels et/ou des tests réels.

14. Programme informatique comprenant un code de programme pour mettre en œuvre le procédé selon l'une des revendications 1 à 13 lorsque le programme informatique est exécuté sur un ordinateur.

15. Support de données lisible par ordinateur, contenant un code d'un programme d'un programme informatique pour mettre en œuvre le procédé selon l'une des revendications 1 à 13 lorsque le programme informatique est exécuté sur un ordinateur.
